# FASCICULE DE BREVET EUROPEEN

(11) **EP 3 726 353 B1**
(45) Date de publication et mention de la délivrance du brevet: **20.04.2022**
(21) Numéro de dépôt: 20178676.1
(22) Date de dépôt: 26.11.2015
(51) Int. Cl.: G06F 3/042, G06F 3/041, H03K 17/94, H03K 17/945, H03K 17/96, G06F 3/0488

(54) **DISPOSITIF ET PROCÉDÉ DE COMMANDE ET APPAREIL COMPORTANT UN TEL DISPOSITIF**
STEUERVORRICHTUNG UND -VERFAHREN UND GERÄT, DAS EINE SOLCHE VORRICHTUNG UMFASST
CONTROL DEVICE AND METHOD AND APPARATUS INCLUDING SUCH A DEVICE

(30) Priorité: 26.11.2014 FR 1461530
(43) Date de publication de la demande: 21.10.2020
(62) Demande divisionnaire de: 15821102.9
(73) Titulaire: Sequeris, 75116 Paris (FR); Falco, Jean-Louis, 75116 Paris (FR)
(72) Inventeur: FALCO, Jean-Louis, 75116 PARIS (FR); PHILIPPE, Sébastien, 30640 Beauvoisin (FR)
(74) Mandataire: Cornuejols, Georges

(56) Documents cités:
- EP-A1- 1 881 605
- EP-A2- 2 360 593
- EP-A2- 2 426 581
- WO-A1-02/35461
- DE-A1-102010 026 910
- US-A1- 2006 244 733
- US-A1- 2011 175 832
- US-A1- 2014 184 541
- US-A1- 2014 213 323
- US-B1- 6 504 530

## Description

### DOMAINE DE L'INVENTION

La présente invention vise un dispositif et un procédé de commande et un appareil comportant un tel dispositif.

La présente invention s'applique au domaine des dispositifs de commande sans ou avec contact. Plus particulièrement, la présente invention s'applique au domaine de la commande d'appareils par un utilisateur.

### ÉTAT DE LA TECHNIQUE

On connaît les interfaces tactiles avec lesquelles un utilisateur touche un écran tactile pour commander des fonctions. Cependant, la sensibilité de ces écrans est variable et la succession d'appuis provoque une usure.

De plus, l'actionnement manuel des équipements mécaniques ou l'appui sur un écran tactile provoquent une trace disgracieuse et, à la longue, un encrassement.

Actuellement, les appareils comportent des boutons poussoirs ou des interrupteurs. Cependant, ces systèmes présentent l'inconvénient d'avoir un fonctionnement détérioré si des débris s'introduisent dans le mécanisme. Aussi, les équipements mécaniques et les écrans tactiles présentent des inconvénients en termes d'hygiène et de risque de contamination, surtout en cas d'usage collectif.

Il existe des appareils comportant des moyens de commande capacitifs. Mais, ces moyens de commande peuvent être déclenchés par des objets, tels un torchon par exemple. En revanche, les touches capacitives ne fonctionnent pas lorsque l'utilisateur porte un gant, sont soumises aux variations d'humidité dans l'air, et doivent être re-calibrées régulièrement. Ainsi, les moyens de commande capacitifs ne sont pas fiables.

On connait la demande de brevet allemand DE 10 2010 026910 qui divulgue un actionneur muni d'un détecteur de présence permettant de désactiver des moyens de verrouillage d'un bouton poussoir, lorsque la présence d'un doigt est détectée pour que l'opérateur puisse appuyer sur le bouton poussoir.

On connait également, la demande de brevet européen EP 2 426 581, le brevet américain US 6 504 530, les demandes de brevet américain US 2014/213 323, US 2014/184 541, US 2011/175 832, US 2006/244 733 et la demande de brevet européen EP 1 881 605 qui représentent l'art antérieur de l'invention.

### OBJET DE L'INVENTION

La présente invention vise à remédier à tout ou partie de ces inconvénients. À cet effet, selon un premier aspect, la présente invention vise un dispositif de commande et procédé correspondante selon les revendications indépendantes.

Grâce à ces dispositions, lorsqu'un utilisateur veut commander une action, il met un objet (notamment un doigt) en regard des moyens de détection, d'une manière stable, donc avec une vitesse inférieure à la valeur prédéterminée, ce qui déclenche la commande d'une action. En revanche, lorsqu'un objet passe rapidement devant les moyens de détection, il ne déclenche aucune action du fait que sa vitesse est supérieure à la valeur prédéterminée.

Dans des modes de réalisation, les moyens de détection sont configurés pour fournir une intensité de détection de l'objet en fonction de l'importance de l'interférence de l'objet avec le chaque champ électromagnétique.

Dans des modes de réalisation, le moyen de commande est configuré pour commander une action si :
- les moyens de détection fournissent une position de l'objet,
- la vitesse de l'objet est inférieure à une valeur prédéterminée et
- l'intensité de détection est croissante ou supérieure à une valeur d'intensité prédéterminée.

Dans des modes de réalisation, la valeur d'intensité prédéterminée est fonction de l'intensité de détection maximale atteinte avant la décroissance de l'intensité de détection.

Grâce à chacune de ces dispositions, les fausses détections sont plus limitées.

Dans des modes de réalisation, le moyen de commande est configuré pour fournir une intensité de détection de l'objet en fonction de l'importance de l'interférence de l'objet avec le chaque champ électromagnétique.

Dans des modes de réalisation, les moyens de détection comportent :
- des premiers moyens de détection :
   - comportant au moins un émetteur d'au moins une onde et au moins un récepteur de l'au moins une onde et
   - détectant la présence et la position d'un objet en fonction de l'au moins une onde reçue et
- des deuxièmes moyens de détection :
   - détectant la présence et la position de l'objet en fonction d'une grandeur physique ;
   - la grandeur physique détectée par les deuxièmes moyens de détection ayant au moins une caractéristique différente de l'onde reçue par les premiers moyens de détection

Grâce à ces dispositions, la détermination de la position de l'objet est plus fiable.

Dans des modes de réalisation, les deuxièmes moyens de détection ne sont activés que si les premiers moyens de détection détectent la présence de l'objet.

Dans des modes de réalisation, si les premiers moyens de détection détectent plusieurs positions d'objet, les moyens de commande commandent une action uniquement si les deuxièmes moyens de détection fournissent une position d'un objet et uniquement en fonction de la position de l'objet fournie par les deuxièmes moyens de détection.

Dans des modes de réalisation, les moyens de détection fournissent une position égale à une moyenne pondérée des positions fournies par les premiers moyens de détection et par les deuxièmes moyens de détection.

Grâce à ces dispositions, la position fournie par les moyens de détection est moyennée, donc plus stable.

Dans des modes de réalisation, le poids affecté à la position fournie par les premiers moyens de détection est fonction d'une intensité de l'interférence de l'objet avec le champ électromagnétique détecté par les premiers moyens de détection et le poids affecté à la position fournie par les deuxièmes moyens de détection est fonction d'une intensité de l'interférence de l'objet avec le champ électromagnétique détecté par les deuxièmes moyens de détection.

Grâce à ces dispositions, une détection parasite de faible intensité par l'un des moyens de détection a peu d'influence sur la position prise en compte.

Dans des modes de réalisation, les moyens de commande sont configurés pour commander une action si :
- les premiers moyens de détection détectent la présence de l'objet,
- les deuxièmes moyens de détection détectent la présence de l'objet et
- la position détectée par les premiers moyens de détection correspond à la position détectée par les deuxièmes moyens de détection.

On permet ainsi une commande avec ou sans contact d'un appareil. De plus, comme deux ondes différentes sont utilisées pour détecter la présence et la position de l'objet, des erreurs de déclenchement de commandes sont évitées et le dispositif présente une plus grande fiabilité. Aussi, comme les deuxièmes moyens de détection ne sont activés que si les premiers moyens de détection détectent la présence de l'objet, une économie d'énergie est réalisée.

De plus, la mise en oeuvre de la présente invention fournit un dispositif de commande présentant les avantages cumulés de deux moyens de commande tout en éliminant, ou au moins réduisant, leurs inconvénients.

Dans des modes de réalisation non couverts par les revendications, les deuxièmes moyens de détection détectent la présence et la position de l'objet sans contact d'un utilisateur avec le dispositif.

La commande sans contact présente l'avantage de limiter l'encrassement et d'éviter un risque de contamination, par exemple.

Dans des modes de réalisation, les deuxièmes moyens de détection détectent la présence et la position de l'objet par contact d'un utilisateur avec le dispositif.

L'avantage de ces modes de réalisation est d'avoir une plus grande précision de la position de l'objet détectée.

Dans des modes de réalisation, les deuxièmes moyens de détection détectent la présence et la position de l'objet par appui d'un utilisateur sur le dispositif.

L'avantage de ces modes de réalisation est d'avoir une position prédéfinie de l'objet détectée au point d'appui.

Dans le mode de réalisation de l'invention, les moyens de commande sont configurés pour commander une action si le moyen de détermination de vitesse détermine que les premiers moyens de détection détectent une vitesse supérieure à la valeur de vitesse prédéterminée et les deuxièmes moyens de détection détectent un appui de l'utilisateur sur le dispositif.

Grâce à ces dispositions, une action est commandée bien que la vitesse initiale de l'objet, déterminée avec les premiers moyens de détection, est supérieure à la valeur de vitesse prédéterminée, l'appui valant détermination d'une vitesse devenant inférieure à la valeur limite de vitesse prédéterminée.

Dans des modes de réalisation, l'onde émise par des moyens de détection est une onde infrarouge.

Ces modes de réalisation présentent l'avantage de permettre la détection d'un doigt d'un utilisateur, sans risquer de détecter un tissu, par exemple.

Dans des modes de réalisation, au moins un émetteur ou un récepteur des moyens de détection est associé à au moins un masque dont la partie transparente, pour au moins une longueur d'onde utilisée par l'émetteur, est allongée dans la direction d'un récepteur capable de détecter l'onde à ladite longueur d'onde.

Un tel masque présente l'avantage de réduire la réception d'ondes parasites.

Dans des modes réalisation, la présence de l'objet est détectée pour une puissance de l'onde reçue, par un récepteur des moyens de détection de présence, inférieure à une valeur limite prédéterminée.

L'avantage de ces modes de réalisation est d'éviter de prendre en considération la présence d'un objet, par exemple très réfléchissant, interagissant fortement avec les moyens de réception, tout en permettant de prendre en compte la présence d'un doigt d'un utilisateur en position d'effectuer une commande.

Dans des modes de réalisation, la grandeur physique détectée par des moyens de détection est une grandeur physique d'une onde électromagnétique. Ces modes de réalisation présentent l'avantage de pouvoir détecter avec précision la présence et la position d'un objet, notamment en utilisant un émetteur et un récepteur capacitifs.

Dans des modes de réalisation, l'onde électromagnétique est une onde radioélectrique.

L'avantage de ces modes de réalisation est d'utiliser les ondes radioélectriques pour détecter la présence d'un objet, ondes qui peuvent être modulées en intensité, fréquence ou phase, pour mieux résister aux ondes parasites et au bruit ambiant.

Dans des modes de réalisation, la présence de l'objet est détectée pour une puissance de l'onde électromagnétique reçue, par un récepteur des moyens de détection de présence, inférieure à une valeur limite prédéterminée.

L'avantage de ces modes de réalisation est d'éviter de détecter la présence d'un objet, capacitif ou en métal par exemple, tout en permettant de détecter la présence d'un doigt d'un utilisateur pour effectuer une commande. Ainsi, une casserole ou une poêle métallique, par exemple, qui, du fait de leur masse métallique, sature les récepteurs, n'est pas prise en considération.

Selon un deuxième aspect, la présence invention vise un procédé de commande conforme à la revendication 10.

Les avantages, buts et caractéristiques particulières du procédé objet de la présente invention étant similaires à ceux du dispositif objet de la présente invention, ils ne sont pas rappelés ici.

Selon un troisième aspect, la présente invention vise un appareil réalisant une fonction, qui comporte au moins un dispositif de commande objet de la présente invention, commandant ladite fonction de l'appareil.

Les avantages, buts et caractéristiques particulières de l'appareil objet de la présente invention étant similaires à ceux du dispositif objet de la présente invention, ils ne sont pas rappelés ici.

### BREVE DESCRIPTION DES FIGURES

D'autres avantages, buts et caractéristiques particuliers de l'invention ressortiront de la description non limitative qui suit d'au moins un mode de réalisation particulier d'un dispositif, d'un procédé de commande et d'un appareil comportant un tel dispositif, en regard des dessins annexés, dans lesquels :
- la figure 1 représente, schématiquement, un mode de réalisation particulier d'un dispositif de commande objet de la présente invention,
- la figure 2 représente, schématiquement, un mode de réalisation particulier de premiers moyens de détection d'un dispositif objet de la présente invention,
- la figure 3 représente, schématiquement, un mode de réalisation particulier de deuxièmes moyens de détection d'un dispositif objet de la présente invention,
- la figure 4 représente, schématiquement, un exemple ne faisant pas partie de l'invention,
- la figure 5 représente, schématiquement, un mode de réalisation particulier d'un appareil objet de la présente invention,
- la figure 6 représente une courbe d'évolution d'une vitesse en fonction du temps,
- la figure 7 représente une courbe d'évolution d'intensité de détection en fonction du temps,
- la figure 8 représente des positions détectées et moyennées,
- la figure 9 représente, sous forme d'un logigramme, un mode de réalisation particulier du procédé objet de la présente invention,
- la figure 10 représente, schématiquement et en coupe, un mode de réalisation particulier d'une partie d'un dispositif objet de la présente invention,
- les figures 11 et 12 représente, schématiquement et en vue de dessus, des exemples de dispositions géométriques de dispositifs le long ou de part et d'autre d'une ligne droite et
- la figure 13 représente, schématiquement et en coupe, un mode de réalisation particulier d'une partie d'un dispositif objet de la présente invention.

### DESCRIPTION D'EXEMPLES DE REALISATION DE L'INVENTION

On note, dès à présent, que les figures ne sont pas à l'échelle.

La présente description est donnée à titre non limitatif, chaque caractéristique d'un mode de réalisation pouvant être combinée à toute autre caractéristique de tout autre mode de réalisation de manière avantageuse.

On note que le terme « un » est utilisé au sens « au moins un ».

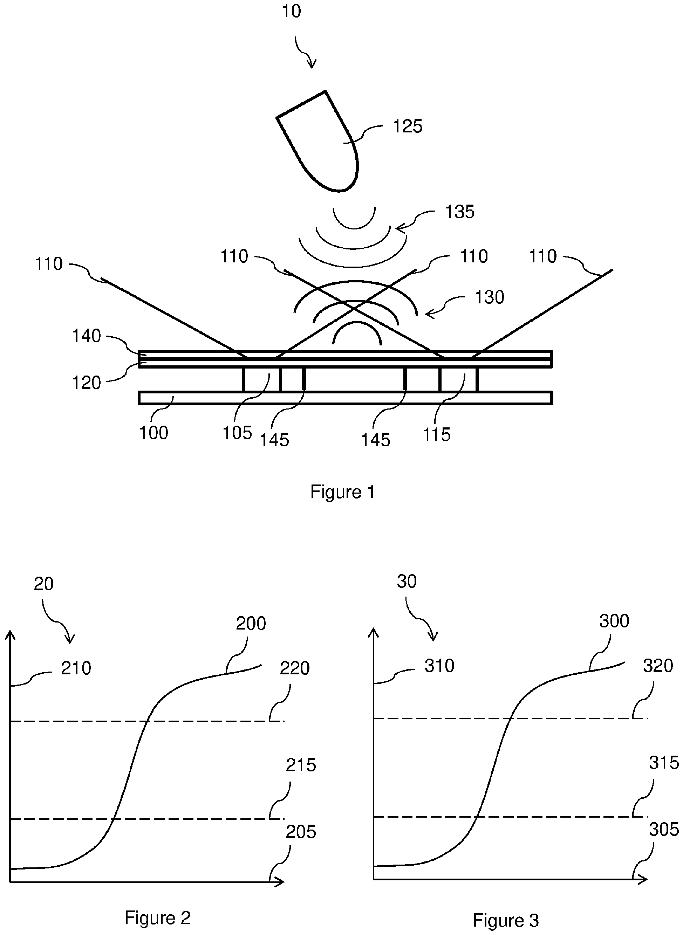

D'une manière générale, la présente invention met en oeuvre au moins un moyen de détection d'un objet interférant avec au moins un champ électromagnétique. L'objet considéré est, préférentiellement, un doigt. Ce champ électromagnétique peut être une onde optique, par exemple infrarouge, un champ électrique ou un champ magnétique. L'interférence peut consister, pour l'objet, à refléter ou à masquer le champ électromagnétique ou à influencer sa valeur mesurée par un détecteur. Chaque moyen de détection est configuré pour estimer une position relative de l'objet par rapport à une surface. Les figures 1 à 5 illustrent des modes de réalisation de l'invention mettant en oeuvre deux ensembles de moyens de détection. Cependant, la présente invention ne se limite pas à ce nombre et peut comporter plus de deux ensembles de moyens de détection.

On observe sur la figure 1, un mode de réalisation particulier 10 d'un dispositif objet de la présente invention.

Le dispositif 10 de commande comporte des premiers moyens de détection, 105, 115 et 120, comportant au moins un émetteur, 105 d'au moins une onde 110 et au moins un récepteur 115 de l'au moins une onde 110 et détectant la présence et la position d'un objet 125 en fonction de l'au moins une onde 110 reçue.

Le dispositif 10 comporte aussi des deuxièmes moyens de détection, 140 et 145, détectant la présence et la position de l'objet 125 en fonction d'une grandeur physique 135.

Les deuxièmes moyens de détection, 140 et 145, ne sont activés que si les premiers moyens de détection, 105, 115 et 120, détectent la présence de l'objet 125.

La grandeur physique détectée par les deuxièmes moyens de détection, 140 et 145, est au moins une caractéristique différente de l'onde 110 reçue par le récepteur 115.

Le dispositif 10 comporte aussi des moyens de commande 100 configurés pour commander une action si :
- les premiers moyens de détection, 105, 115 et 120, détectent la présence de l'objet 125,
- les deuxièmes moyens de détection, 125, 140 et 145, détectent la présence de l'objet 125 et
- la position détectée par les premiers moyens de détection, 105, 115 et 120, correspond à la position détectée par les deuxièmes moyens de détection, 140 et 145.

Préférentiellement, les premiers moyens de détection, 105, 115 et 120, sont des moyens de détection dont chaque émetteur émet une onde 110 infrarouge, et dont chaque récepteur capte une onde infrarouge. Préférentiellement, les premiers moyens de détection, 105, 115 et 120, comportent une dalle 120, de répartition des ondes infrarouges 110.

L'onde 110 émise par l'émetteur 105 est répartie par la dalle 120. L'onde 110 se réfléchit sur un objet 125 qui réfléchit des ondes infrarouges et est captée par un récepteur 115. La présence de l'objet 125 est donc détectée par les premiers moyens de détection, 105, 115 et 120. Si l'objet 125 absorbe les ondes infrarouges, la présence de l'objet 125 n'est pas détectée par les premiers moyens de détection, 105, 115 et 120. La position de l'objet 125 est détectée en fonction de l'endroit sur la dalle infrarouge 120 où l'onde 110 est réfléchie, par exemple.

L'utilisation d'ondes infrarouges présente l'avantage de permettre la détection d'un doigt d'un utilisateur, sans risquer de détecter un tissu, par exemple.

Dans des modes de réalisation, l'émetteur 105 est entouré de symboles situés entre ledit émetteur et au moins un récepteur 115. La surface du dispositif 10 est opaque pour les longueurs d'ondes utilisées, sauf en regard du récepteur 115. En regard de l'émetteur 105, la surface du dispositif 10 est, au moins partiellement, transparente pour ces longueurs d'ondes, sur une zone allongée vers le récepteur. Ainsi, la puissance des ondes émises par l'émetteur 105 est plus importante dans la direction du récepteur 110 que dans les autres directions. La zone allongée définit ainsi un masque, dont la partie transparente, pour au moins une longueur d'onde utilisée par l'émetteur 105, est allongée dans la direction d'un récepteur 115 capable de détecter l'onde à ladite longueur d'onde. Ce masque dont la partie transparente, pour au moins une longueur d'onde utilisée par l'émetteur 105, est allongé dans la direction d'un récepteur 115 capable de détecter l'onde 110 à ladite longueur d'onde. Ce masque peut être rectangulaire ou elliptique, par exemple, la plus grande dimension du masque étant sensiblement parallèle à la droite reliant l'émetteur 105 et le récepteur 110. Dans des modes de réalisation, un tel masque est positionné en regard d'un récepteur 115, éventuellement en combinaison avec un tel masque positionné en regard d'un émetteur 105.

Préférentiellement, la grandeur physique 135 détectée par les deuxièmes moyens de détection, 140 et 145, est une grandeur physique d'une onde électromagnétique. Préférentiellement, les deuxièmes moyens de détection, 140 et 145, comportent un émetteur 140 d'une onde électromagnétique 130 et un récepteur 145 d'une onde électromagnétique 135.

Préférentiellement, les deuxièmes moyens de détection, 140 et 145, sont des moyens de détection dont un émetteur est une dalle 140 capacitive. La dalle capacitive est une surface parcourue par une grille accumulant une charge sur toute la surface de la dalle. L'onde 130 émise par la dalle 140 est déphasée par un objet 125 conducteur sans contact de l'objet 125 conducteur avec la dalle capacitive 140. L'onde 135 déphasée est captée par un récepteur capacitif 145. La présence d'un objet 125 est donc détectée. Si l'objet 125 n'est pas conducteur la présence de l'objet 125 n'est pas détectée par les deuxièmes moyens de détection, 140 et 145. Préférentiellement, l'onde 135 est une onde électromagnétique.

Dans des modes de réalisation, les deuxièmes moyens de détection, 140 et 145, sont des moyens de détection dont un émetteur est une dalle 140 capacitive. L'onde 130 émise par la dalle 140 est déphasée par un objet 125 conducteur en contact avec la dalle capacitive 140. L'onde 135 déphasée est captée par un récepteur capacitif 145. La présence d'un objet 125 est donc détectée. Si l'objet 125 n'est pas conducteur la présence de l'objet 125 n'est pas détectée par les deuxièmes moyens, 140 et 145, de détection.

La commande sans contact présente l'avantage de limiter l'encrassement et d'éviter un risque de contamination, par exemple.

Dans des modes de réalisation, les deuxièmes moyens de détection, 140 et 145, sont des moyens de détection comportant une dalle 140 résistive. La dalle 140 résistive est une surface parcourue par une grille accumulant une charge électrique sur toute la surface de la dalle. Lorsqu'un utilisateur appuie sur la dalle 140 résistive, un point de contact est créé et la présence d'un objet 125 est détectée.

L'avantage de la détection de présence et de position de l'objet par contact d'un utilisateur est d'avoir une plus grande précision de la position de l'objet détectée.

Dans des modes de réalisation, les premiers moyens de détection, 105, 115 et 120, et les deuxièmes moyens de détection, 140 et 145, sont :
- des moyens de détection par infrarouges,
- des moyens de détection capacitifs,
- des moyens de détection par radiofréquences,
- des moyens de détection par ondes radioélectriques,
- des moyens de détection résistifs,
- des moyens de détection thermiques,
- des moyens de détection mécaniques où
- tout autre moyen de détection.

Bien que le mode de réalisation 10 de l'invention représenté dans les figures 1 à 5 soit un mode de réalisation dans lequel les premiers moyens de détection, 105, 115 et 120, sont des moyens de détection infrarouge et les deuxièmes moyens de détection, 140 et 145, sont des moyens de détection capacitifs. D'autres modes de réalisation dans lesquels les moyens de détection cités ci-dessus sont mis en œuvre font partie de l'objet de la présente invention.

La position de l'objet 125 détectée par les deuxièmes moyens de détection, 140 et 145, est déterminée en fonction de l'emplacement dans la dalle capacitive à laquelle le signal 130 émis est déformé.

Dans des modes de réalisation, les deuxièmes moyens de détection, 140 et 145, ne sont activés que si les premiers moyens de détection, 105, 115 et 120, détectent la présence de l'objet 125.

Dans des modes de réalisation, les premiers moyens de détection, 105, 115 et 120, ne sont activés que si les deuxièmes moyens de détection, 140 et 145, détectent la présence de l'objet 125.

Les moyens de commande 100 sont configurés pour commander une action si :
- les premiers moyens de détection, 105, 115 et 120, détectent la présence de l'objet 125,
- les deuxièmes moyens de détection, 125, 140 et 145, détectent la présence de l'objet 125 et
- la position détectée par les premiers moyens de détection, 105, 115 et 120, correspond à la position détectée par les deuxièmes moyens de détection, 140 et 145.

L'action commandée est une action d'augmentation de la température, de diminution de la température ou de mise en fonctionnement d'un minuteur, par exemple. L'action commandée est en fonction de la position détectée.

On observe sur la figure 2, un premier mode de réalisation 20 de premiers moyens de détection, 105, 115 et 120, d'un dispositif 10 objet de la présente invention.

Le mode de réalisation 20 est illustré par un graphique montrant un signal 200 représentatif d'une onde 110 reçue par les premiers moyens de détection, 105, 115 et 120. Le signal 200 est représenté dans le graphique 20 comportant en abscisse 205, le temps, et en ordonnée 210, une puissance reçue.

Le mode de réalisation 20 comporte :
- une valeur limite prédéterminée de puissance 215, dite « valeur basse » et
- une valeur limite prédéterminée de puissance 220, dite « valeur haute ».

Si la puissance du signal 200 est inférieure à la valeur basse 215, les premiers moyens de détection, 105, 115 et 120, ne détectent pas l'objet 125. Si la puissance du signal 200 est supérieure à la valeur haute 220, les premiers moyens de détection, 105, 115 et 120, ne détectent pas l'objet 125. Si la puissance du signal 200 est inférieure à la valeur haute 220 et supérieure à la valeur basse 215, les premiers moyens de détection, 105, 115 et 120, détectent la présence d'un objet 125.

Grâce à la mise en œuvre de la valeur limite haute 220, on évite de détecter des objets, par exemple métalliques, qui auraient une interaction avec les premiers moyens de détection, 105, 115 et 120, très supérieure à l'interaction provoquée par le doigt d'un utilisateur.

On observe sur la figure 3, un premier mode de réalisation 30 de deuxièmes moyens de détection, 140 et 145, d'un dispositif 10 objet de la présente invention.

Le mode de réalisation 30 est illustré par un graphique montrant un signal 300 représentatif d'une onde 135 reçue par les deuxièmes moyens de détection, 140 et 145. Le signal 300 est représenté dans le graphique 30 comportant en abscisse 305, le temps, et en ordonnée 310, une puissance d'une grandeur physique.

Le mode de réalisation 30 comporte :
- une valeur limite prédéterminée de puissance 315, dite « valeur basse » et
- une valeur limite prédéterminée de puissance 320, dite « valeur haute ».

Si la puissance du signal 300 est inférieure à la valeur basse 315, les deuxièmes moyens de détection, 140 et 145, ne détectent pas l'objet 125. Si la puissance du signal 300 est supérieure à la valeur haute 320, les deuxièmes moyens de détection, 140 et 145, ne détectent pas l'objet 125. Si la puissance du signal 300 est inférieure à la valeur haute 320 et supérieure à la valeur basse 315, les deuxièmes moyens de détection, 140 et 145, détectent la présence d'un objet 125.

Grâce à la mise en œuvre de la valeur limite haute 320, on évite de détecter des objets, par exemple métalliques, qui auraient une interaction avec les deuxièmes moyens de détection, 140 et 145, très supérieure à l'interaction provoquée par le doigt d'un utilisateur.

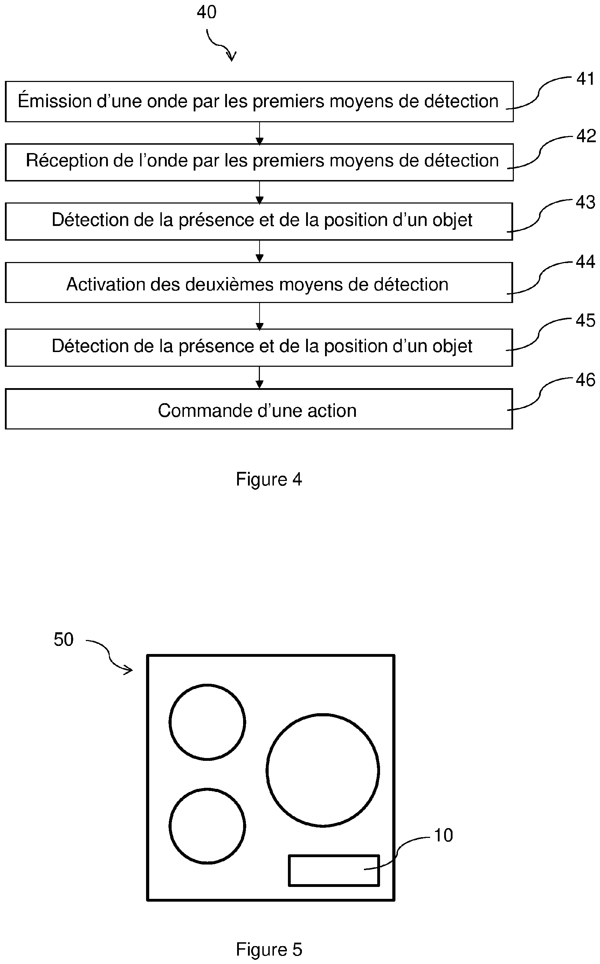

On observe sur la figure 4, un exemple d'un procédé ne faisant pas partie de l'invention.

Le procédé 40 de commande comporte les étapes suivantes :
- émission 41 d'au moins une onde 110, par un émetteur 105 de premiers moyens de détection, 105, 115 et 120,
- réception 42 de l'au moins une onde 110, par un récepteur 115 de premiers moyens de détection, 105, 115 et 120,
- détection 43 de la présence et de la position d'un objet 125 au moyen de l'au moins une onde 110 reçue,
- activation 44 de deuxièmes moyens de détection, 140 et 145,
- détection 45 de la présence et de la position d'un objet 125 en fonction d'une grandeur physique 135,
- commande 46 d'une action si la position détectée par les premiers moyens de détection, 105, 115 et 120, correspond à la position détectée par les deuxièmes moyens de détection, 140 et 145.

Préférentiellement, le procédé 40 de commande est mis en œuvre par un dispositif 10 de commande objet de la présente invention.

Au cours de l'étape d'émission 41, l'onde 110 émise par l'émetteur 105 est répartie par la dalle 120. L'onde 110 se réfléchit sur un objet 125 qui réfléchit des ondes infrarouges et est reçue par un récepteur 115, à l'étape 42 de réception. La détection de la présence de l'objet 125 est mise en œuvre par les premiers moyens de détection, 105, 115 et 120. Si l'objet 125 absorbe les ondes infrarouges, l'étape 43 de détection n'est pas effectuée. La détection 43 de la position de l'objet 125 est en fonction de l'endroit sur la dalle infrarouge 120 ou l'onde 110 est réfléchie, par exemple.

Une fois la présence de l'objet 125 détectée, le procédé 40 passe à l'étape 44 d'activation des deuxièmes moyens de détection, 140 et 145.

Préférentiellement, l'étape de détection 45 est en fonction d'une grandeur physique 135 et la grandeur physique 135 est une grandeur physique d'une onde électromagnétique.

Lors de l'étape de détection 45, la position de l'objet 125 détectée par les deuxièmes moyens de détection, 140 et 145, est déterminée en fonction de l'emplacement dans la dalle capacitive à laquelle le signal 130 émis est le plus modulé.

Le procédé 40 comporte une étape de comparaison de la position détectée par les premiers moyens de détection à l'étape 43 et de la position détectée par les deuxièmes moyens de détection à l'étape 45. Si les positions détectées se correspondent, le procédé 40 passe à l'étape 46 de commande d'une action.

On a correspondance entre deux positions lorsque ces positions détectées ont sensiblement les mêmes coordonnées dans un même repère, en une ou deux dimensions, par exemple un repère orthogonal. Cette correspondance est donc déterminée avec une tolérance.

L'étape de commande 46 d'une action est mise en œuvre si :
- une présence de l'objet 125 est détectée à l'étape 43 de détection,
- une présence de l'objet 125 est détectée à l'étape 45 de détection et
- la position détectée à l'étape 43 de détection correspond à la position détectée à l'étape 45 de détection.

L'action commandée est une action d'augmentation de la température, de diminution de la température ou de mise en fonctionnement d'un minuteur, par exemple. L'action commandée est en fonction de la position détectée.

Comme on le comprend à la lumière de la description qui précède, la mise en œuvre de la présente invention permet ainsi une commande avec ou sans contact d'un appareil. De plus, comme deux ondes différentes sont utilisées pour détecter la présence et la position de l'objet, des erreurs de déclenchement de commandes sont évitées et le dispositif présente une plus grande fiabilité. Aussi, comme les deuxièmes moyens de détection ne sont activés que si les premiers moyens de détection détectent la présence de l'objet, une économie d'énergie est réalisée.

De plus, la mise en œuvre de la présente invention présente l'avantage de proposer un dispositif de commande présentant les avantages cumulés de deux moyens de commande tout en éliminant, ou au moins réduisant, leurs inconvénients.

On observe sur la figure 5, un mode de réalisation 50 d'un appareil objet de la présente invention.

L'appareil 50 présente au moins une fonction et comporte au moins un dispositif de commande objet de la présente invention, commandant au moins cette fonction.

Dans des modes de réalisation, l'appareil 50 est un appareil médical ou un ascenseur, par exemple. L'appareil 50 peut aussi être un appareil électroménager, par exemple qui comporte des plaques de cuisson ou un four dont le fonctionnement est commandé par un dispositif de commande objet de la présente invention.

Les commandes de l'appareil 50 sont effectuées par un utilisateur au moyen d'un dispositif 10 de commande. Les commandes sont préférentiellement effectuées sans contact de l'utilisateur avec l'appareil 50. Dans des modes de réalisation, les commandes sont effectuées avec contact de l'utilisateur avec l'appareil 50.

L'action commandée est une action d'augmentation de la température, de diminution de la température ou de mise en fonctionnement d'un minuteur, par exemple. L'action commandée est en fonction de la position détectée d'une partie du corps de l'utilisateur par rapport au dispositif 10 de commande.

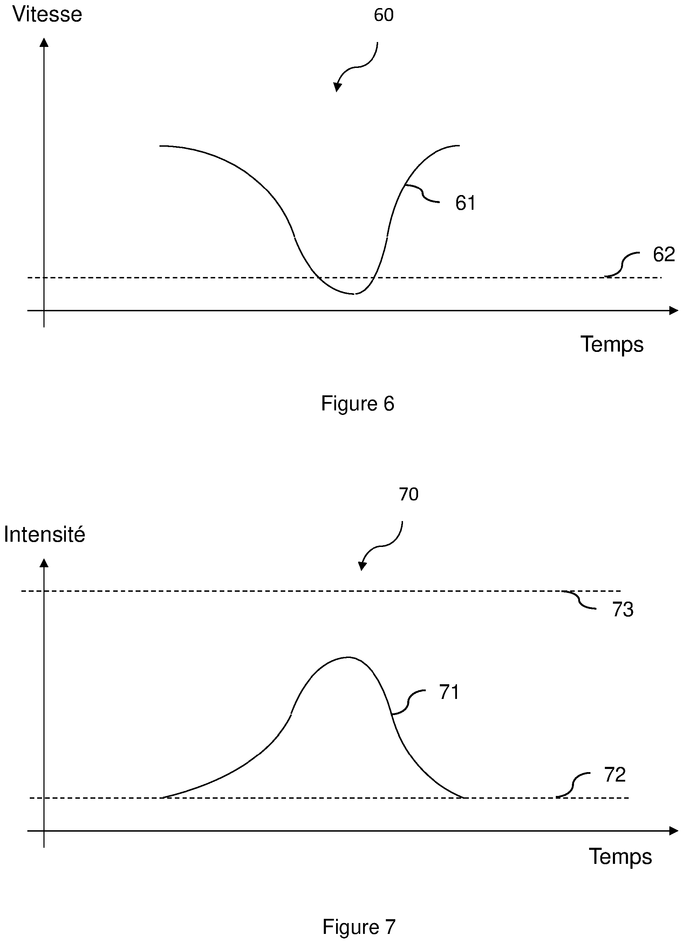

On observe, en figure 6, une courbe 60 d'évolution au cours du temps d'une vitesse 61 de déplacement de la position d'un objet détecté par au moins un moyen de détection de l'objet.

Comme exposé en regard des figures 1 à 5, les moyens de détection fournissent une estimation de la position de l'objet. La vitesse de l'objet est déterminée, selon au moins un axe, par différence de position entre deux instants.

Ainsi, les moyens de détection sont configurés pour fournir une position d'un objet interférant avec au moins un champ électromagnétique et un moyen de détermination de vitesse fournit une vitesse de déplacement de l'objet, en fonction de la position de l'objet fournie par les moyens de détection.

Dans des modes de réalisation préférentiels, on compare la vitesse ainsi déterminée avec une valeur limite prédéterminée 62. Par exemple, la valeur limite prédéterminée 62 vaut un centimètre par seconde.

Les moyens de commande sont configurés pour commander une action si :
- les moyens de détection fournissent une position de l'objet et
- la vitesse de l'objet est inférieure à une valeur de vitesse prédéterminée.

L'action commandée est celle qui est associée à la position de l'objet lorsque sa vitesse atteint la valeur limite prédéterminée ou lorsque la vitesse atteint sa valeur minimale et que cette valeur minimale est inférieure à la valeur limite prédéterminée.

La valeur limite prédéterminée peut être fixée par construction ou peut faire l'objet d'un réglage par l'utilisateur ou d'un apprentissage par le dispositif, par exemple pendant une phase d'installation pendant laquelle il est demandé à l'utilisateur de pointer son doigt vers chaque symbole représentant une action susceptible d'être commandée par le dispositif de commande objet de la présente invention.

La figure 7 représente une courbe 70 d'évolution de l'intensité de l'interférence entre l'objet et le champ électromagnétique détecté par les moyens de détection. La détection est effectuée lorsque cette intensité est comprise entre une valeur minimale d'intensité limite prédéterminée 72 et une valeur maximale d'intensité limite prédéterminée 73.

Par exemple, la valeur minimale d'intensité limite prédéterminée 72 vaut deux fois l'intensité du bruit ambiant mesuré. Par exemple, la valeur maximale d'intensité limite prédéterminée 73 vaut trois quarts de la valeur de saturation des moyens de détection. Selon un autre exemple, la valeur maximale d'intensité limite prédéterminée 73 est supérieure à l'intensité maximale constatée pendant une phase d'apprentissage avec un échantillon d'objets, par exemple de doigts, représentatif de la diversité humaine de morphologies et de couleurs de peau.

Ainsi, les moyens de détection sont configurés pour fournir une intensité de détection de l'objet en fonction de l'importance de l'interférence de l'objet avec le chaque champ électromagnétique.

Préférentiellement, le moyen de commande est configuré pour commander une action si :
- les moyens de détection fournissent une position de l'objet,
- la vitesse de l'objet est inférieure à une valeur prédéterminée et
- l'intensité de détection est croissante ou supérieure à une valeur d'intensité prédéterminée.

Préférentiellement, la valeur d'intensité prédéterminée est fonction de l'intensité de détection maximale atteinte avant la décroissance de l'intensité de détection. Par exemple, la valeur d'intensité prédéterminée est égale à la moitié ou les trois quarts de l'intensité maximale atteinte.

L'inventeur a déterminé que, cette valeur limite permet d'éviter des fausses détections.

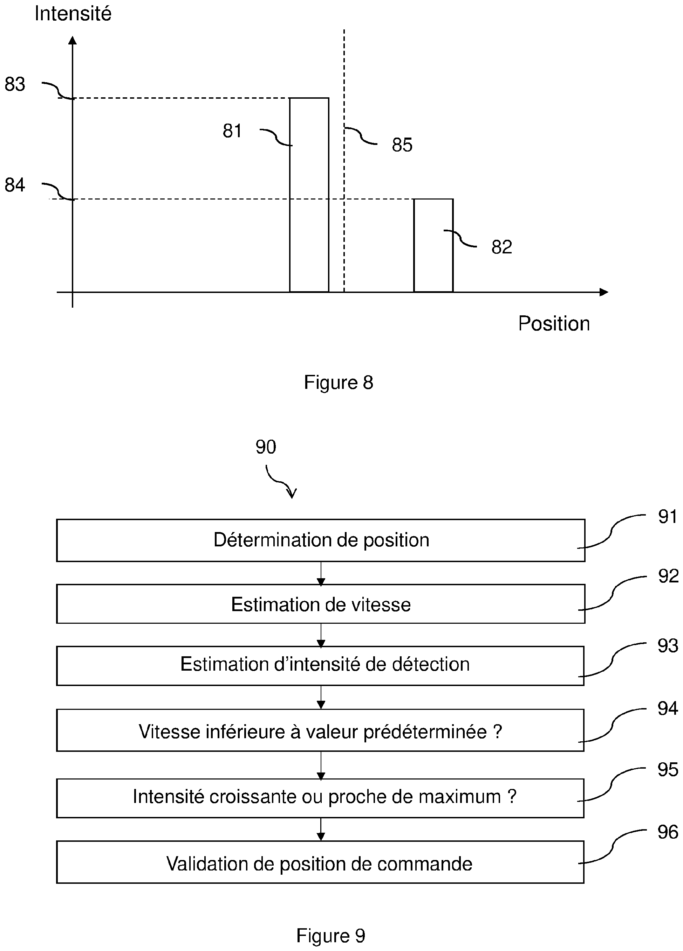

La figure 8 représente des positions 81 et 82 détectées par des premiers et des deuxièmes moyens de détection de l'objet, respectivement, ainsi que les intensités 83 et 84 de détection (c'est-à-dire d'interférence avec les champs électromagnétiques mis en œuvre par les différents ensembles de moyens de détection).

Dans des modes de réalisation, les moyens de détection fournissent une position 85 égale à une moyenne pondérée des positions fournies par les premiers moyens de détection et par les deuxièmes moyens de détection.

Préférentiellement, le poids affecté la position fournie par les premiers moyens de détection est fonction d'une intensité de l'interférence de l'objet avec le champ électromagnétique détecté par les premiers moyens de détection et le poids affecté à la position fournie par les deuxièmes moyens de détection est fonction d'une intensité de l'interférence de l'objet avec le champ électromagnétique détecté par les deuxièmes moyens de détection.

La position ainsi fournie est ainsi plus stable et plus fidèle à la position effective de l'objet.

On observe, en figure 9, des étapes 91 à 96 d'un procédé 90 de commande objet de la présente invention.

Ce procédé comporte les étapes suivantes :
- une étape 91 de détection fournissant une position d'un objet interférant avec un champ électromagnétique,
- une étape 92 de détermination d'une vitesse de déplacement de l'objet, en fonction de la position de l'objet fournie par les moyens de détection,
- une étape 93 d'estimation de l'intensité de détection,
- une étape 94 de détermination si la vitesse est inférieure à une valeur prédéterminée,
- une étape 95 de détermination si l'intensité de détection est croissante ou proche d'un maximum (c'est-à-dire que sa valeur est supérieure à une valeur fonction de l'intensité maximale, comme exposé ci-dessus) et
- si les étapes 94 et 95 fournissent des résultats positifs, une étape de commande d'une action associée à la position de l'objet.

Dans des variantes, les étapes 93 et 95 sont éliminées.

Dans des modes de réalisation, les moyens de commande sont configurés pour commander une action si le moyen de détermination de vitesse détermine que les premiers moyens de détection détectent une vitesse supérieure à la valeur de vitesse prédéterminée et les deuxièmes moyens de détection détectent un appui de l'utilisateur sur le dispositif.

Grâce à ces dispositions, une action est commandée bien que la vitesse initiale de l'objet, déterminée avec les premiers moyens de détection, est supérieure à la valeur de vitesse prédéterminée, l'appui valant détermination d'une vitesse devenant inférieure à la valeur limite de vitesse prédéterminée.

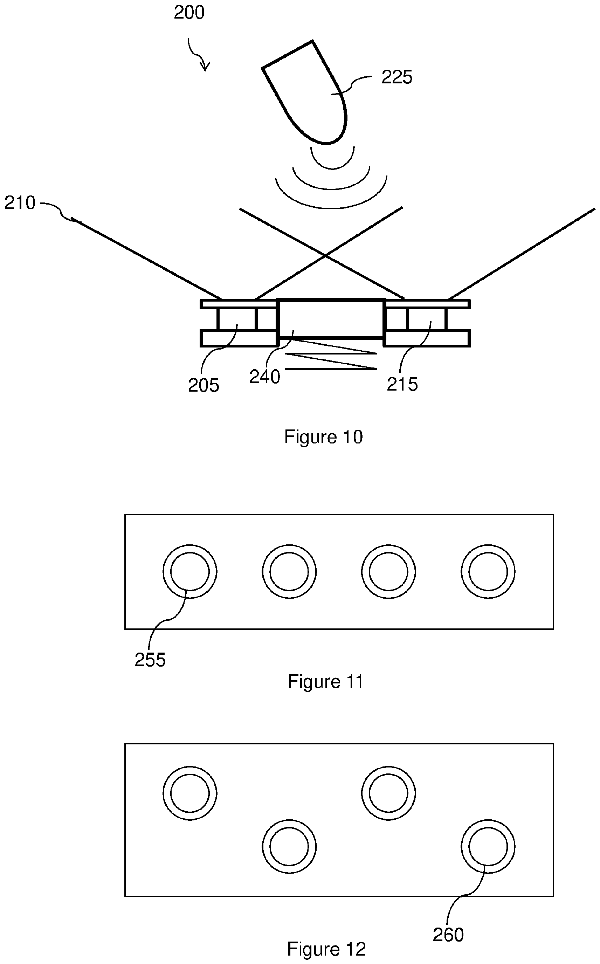

On observe sur la figure 10, un mode de réalisation particulier 200 d'un dispositif objet de la présente invention.

Le dispositif 200 de commande comporte des premiers moyens de détection, 205, 215, comportant au moins un émetteur, 205 de rayons infrarouges 210 et au moins un récepteur 215 des rayons infrarouges 210 réfléchis par l'objet 225. Les premiers moyens de détection sont constitués d'une dalle infrarouge. Préférentiellement, chaque émetteur 205 et chaque récepteur 215 est un émetteur-récepteur de rayons infrarouges.

Le dispositif 200 comporte aussi des deuxièmes moyens de détection, 240, détectant la présence et la position de l'objet 225 en fonction d'un appui de l'objet 225 sur les deuxièmes moyens de détection. Les deuxièmes moyens de détection sont constitués d'un bouton mécanique mobile, par exemple un bouton interrupteur.

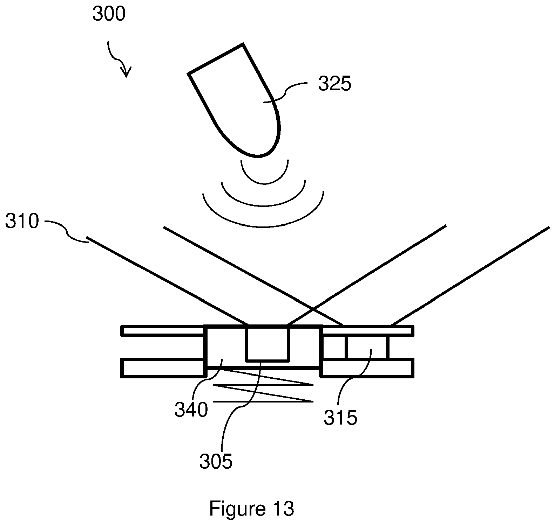

On observe sur la figure 13, un mode de réalisation particulier 300 d'un dispositif objet de la présente invention.

Le dispositif 300 de commande comporte des premiers moyens de détection, 305, 315, comportant au moins un émetteur, 305 de rayons infrarouges 310 et au moins un récepteur 315 des rayons infrarouges 310 réfléchis par l'objet 325. Les premiers moyens de détection sont constitués d'une dalle infrarouge. Préférentiellement, chaque émetteur 305 et chaque récepteur 315 est un émetteur-récepteur de rayons infrarouges.

Le dispositif 300 comporte aussi des deuxièmes moyens de détection, 340, détectant la présence et la position de l'objet 325 en fonction d'un appui de l'objet 325 sur les deuxièmes moyens de détection. Les deuxièmes moyens de détection sont constitués d'un bouton mécanique mobile, par exemple un bouton interrupteur.

Dans ce mode de réalisation, un émetteur 305 de rayons infrarouges se situe dans la partie mobile centrale du bouton mécanique mobile 340. En variante, un récepteur de rayons infrarouges se situe dans la partie mobile centrale du bouton mécanique mobile.

Les figures 11 et 12 illustrent des exemples de combinaisons de plusieurs dispositifs tels qu'illustrés en figure 10, permettant de créer un réseau maillé. Un des avantages de la mise en œuvre de la présente invention est la possibilité de relier les boutons entre eux afin d'en faire un réseau maillé intelligent. Si le système détecte que plusieurs dispositifs sont activés simultanément, il ne tient pas compte de la détection infrarouge et ne prend en compte que la détection mécanique.

On peut également (puisque le bouton mécanique est couplé au système infrarouge et à son « intelligence », repérer les dysfonctionnements mécaniques (usure des pièces)

La figure 11 illustre une disposition de dispositifs 255 le long d'une ligne droite.

La figure 12 illustre une disposition de dispositifs 255 alternativement de part et d'autre d'une ligne droite.

La position et la vitesse de l'objet évoquées en regard des figures, notamment figures 6 et 8, sont déterminées le long de cette ligne droite.

Dans tous les modes de réalisation, un indicateur, sonore ou visuel (voyant) peut être ajouté pour signaler que l'objet a été détecté et l'action validée. Dans les modes de réalisation comportant un bouton (voir, par exemple, figures 10 et 13), un voyant lumineux peut être placé au centre du bouton ou à l'extérieur du bouton.

## Revendications

1. Dispositif (10) de commande, comportant au moins un symbole représentant une action susceptible d'être commandée par le dispositif de commande, comportant
- des premiers moyens de détection sans contact :
- comportant au moins un émetteur (105, 205, 305) d'au moins une onde (110, 210, 310) et au moins un récepteur (115, 215, 315) de l'au moins une onde et
- détectant la présence et la position d'un objet (125, 225, 325) en fonction de l'au moins une onde reçue et
- des deuxièmes moyens de détection (240, 340) par contact, détectant la présence et la position de l'objet (125, 225, 325) en fonction d'un appui de l'objet sur les deuxièmes moyens de détection, la grandeur physique détectée par les deuxièmes moyens de détection ayant au moins une caractéristique différente de l'onde reçue par les premiers moyens de détection,
- un moyen de détermination d'une vitesse de déplacement de l'objet en fonction de la position de l'objet fournie par les premiers moyens de détection et
- des moyens (100) de commande configurés pour commander une action représentée par un symbole en regard des moyens de détection si :
- les premiers moyens de détection fournissent une position de l'objet et le moyen de détermination de la vitesse de déplacement de l'objet détermine une vitesse de déplacement de l'objet inférieure à une valeur de vitesse prédéterminée ou
- les premiers moyens de détection fournissent une position de l'objet et le moyen de détermination de la vitesse de déplacement de l'objet détermine une vitesse supérieure à la valeur de vitesse prédéterminée et les deuxièmes moyens de détection détectent un appui de l'utilisateur sur le dispositif.

2. Dispositif (10) selon la revendication 1, dans lequel les premiers moyens de détection sont configurés pour fournir une intensité de détection de l'objet (125, 225, 325) en fonction de l'importance de l'interférence de l'objet avec au moins un champ électromagnétique, dans lequel les moyens (100) de commande sont configurés pour commander une action si :
- les moyens de détection fournissent une position de l'objet,
- la vitesse de l'objet (125, 225, 325) est inférieure à la valeur prédéterminée et
- l'intensité de détection est croissante ou supérieure à une valeur d'intensité prédéterminée fonction de l'intensité de détection maximale atteinte avant la décroissance de l'intensité de détection.

3. Dispositif (10) selon l'une des revendications 1 ou 2, dans lequel les deuxièmes moyens de détection ne sont activés que si les premiers moyens de détection détectent la présence de l'objet (125, 225, 325).

4. Dispositif selon l'une des revendications 1 à 3, dans lequel si les premiers moyens de détection détectent plusieurs positions d'objet correspondant à plusieurs deuxièmes moyens de détection associés à différentes actions à commander, les moyens de commande commandent une action uniquement si les deuxièmes moyens de détection fournissent une position d'un objet et uniquement en fonction de la position de l'objet fournie par les deuxièmes moyens de détection.

5. Dispositif (10) selon l'une des revendications revendication 1 à 4, dans lequel un champ électromagnétique détecté par les premier moyens de détection prend la forme d'une onde infrarouge, dans lequel au moins un émetteur (105) ou un récepteur (115) des premiers moyens (105, 115 et 120) de détection est associé à au moins un masque dont la partie transparente, pour au moins une longueur d'onde utilisée par l'émetteur, est allongée dans la direction d'un récepteur capable de détecter l'onde (110, 200) à ladite longueur d'onde.

6. Dispositif (10) selon l'une des revendications revendication 1 à 5, dans lequel un champ électromagnétique détecté par les premiers moyens de détection prend la forme d'une onde infrarouge, dans lequel la présence de l'objet (125, 225, 325) est détectée pour une puissance (210) de l'onde (200) reçue, par un récepteur (115) des premiers moyens (105, 115 et 120) de détection de présence, inférieure à une valeur limite prédéterminée (220).

7. Dispositif (10) selon l'une des revendications 1 à 6, dans lequel les premiers moyens de détection sont configurés pour détecter la présence de l'objet (125, 225, 325) pour une intensité d'interférence de l'objet sur le champ électromagnétique inférieure à une valeur limite prédéterminée (320).

8. Dispositif selon la revendication 7, dans lequel la valeur maximale d'intensité limite prédéterminée vaut trois quarts de la valeur de saturation des moyens de détection et/ou est supérieure à l'intensité maximale constatée pendant une phase d'apprentissage avec un échantillon d'objets, par exemple de doigts, représentatif de la diversité humaine de morphologies et de couleurs de peau.

9. Dispositif selon l'une des revendications 1 à 7, dans lequel la valeur de vitesse limite prédéterminée est fixée apprentissage par le dispositif pendant une phase d'installation pendant laquelle il est demandé à l'utilisateur de pointer son doigt vers chaque symbole représentant une action susceptible d'être commandée par le dispositif de commande objet de la présente invention, la valeur minimale d'intensité limite prédéterminée valant, par exemple, deux fois l'intensité du bruit ambiant mesuré.

10. Procédé (40) de commande d'une action représentée par un symbole, comportant Z les étapes suivantes :
- détection sans contact d'une présence et d'une position d'un objet interférant avec un champ électromagnétique en regard du symbole,
- détermination d'une vitesse de déplacement de l'objet, en fonction de la position de l'objet détectée et
- commande d'une action si la vitesse de l'objet est inférieure à une valeur de vitesse prédéterminée ou si la vitesse de l'objet est supérieure à la valeur de vitesse prédéterminée et un appui de l'utilisateur sur le dispositif est détecté par contact.

11. Appareil (50) réalisant une fonction commandée par une action d'un utilisateur, **caractérisé en ce qu'**il comporte au moins un dispositif (10) de commande selon l'une des revendications 1 à 8, commandant ladite fonction de l'appareil.

12. Appareil (50) selon la revendication 11, constituant un appareil médical.

13. Appareil (50) selon la revendication 11, constituant un ascenseur.

14. Appareil (50) selon la revendication 11, constituant un appareil électroménager.

## Patentansprüche

1. Steuervorrichtung (10), umfassend wenigstens ein Symbol, das eine Wirkung darstellt, die geeignet ist, von der Steuervorrichtung gesteuert zu sein, umfassend:
- erste Detektionsmittel ohne Kontakt:
- die wenigstens einen Sender (105, 205, 305) wenigstens einer Welle (110, 210, 310) und wenigstens einen Sender (115, 215, 315) der wenigstens einen Welle umfassen und
- das Vorhandensein und die Position eines Objekts (125, 225, 325) in Abhängigkeit von der wenigstens einen empfangenen Welle detektieren und
- zweite Detektionsmittel (240, 340) mit Kontakt, die das Vorhandensein und die Position des Objekts (125, 225, 325) in Abhängigkeit von einem Aufdrücken des Objekts auf den zweiten Detektionsmitteln detektieren, wobei die physikalische Größe, die von den zweiten Detektionsmitteln detektiert ist und wenigstens ein unterschiedliches Merkmal der von den ersten Detektionsmitteln empfangenen Welle aufweist,
- ein Bestimmungsmittel einer Verschiebungsgeschwindigkeit des Objekts in Abhängigkeit von der Position des Objekts, die von den ersten_Detektionsmitteln geliefert ist, und
- Steuermittel (100) die zum Steuern einer Aktion ausgestaltet sind, die von einem Symbol gegenüber den Detektionsmitteln dargestellt ist, wenn:
- die ersten Detektionsmittel eine Position des Objekts liefern und das Bestimmungsmittel der Verschiebungsgeschwindigkeit des Objekts eine Verschiebungsgeschwindigkeit des Objekts bestimmt, die niedriger ist als ein vorbestimmter Geschwindigkeitswert oder
- die ersten Detektionsmittel eine Position des Objekts liefern und das Bestimmungsmittel der Verschiebungsgeschwindigkeit des Objekts eine Geschwindigkeit, die höher ist als der vorbestimmte Geschwindigkeitswert bestimmt, und die zweiten Detektionsmittel ein Aufdrücken des Nutzers auf der Vorrichtung detektieren.

2. Vorrichtung (10) gemäß Anspruch 1, bei der die ersten Detektionsmittel ausgestaltet sind, um eine Detektionsintensität des Objekts (125, 225, 325) in Abhängigkeit von der Stärke der Interferenz des Objekts mit wenigstens einem elektromagnetischen Feld zu liefern, bei der die Steuermittel (100) zum Steuern einer Aktion ausgestaltet sind, wenn:
- die Detektionsmittel eine Position des Objekts liefern,
- die Geschwindigkeit des Objekts (125, 225, 325) niedriger ist als der vorbestimmte Wert und
- die Detektionsintensität ansteigend oder höher ist als ein vorbestimmter Intensitätswert, der von der maximalen Detektionsintensität abhängt, die vor dem Abnehmen der Detektionsintensität erreicht ist abhängig ist.

3. Vorrichtung (10) gemäß irgendeinem der Ansprüche 1 oder 2, bei der die zweiten Detektionsmittel nur aktiviert sind, wenn die ersten Detektionsmittel das Vorhandensein des Objekts (125, 225, 325) detektieren.

4. Vorrichtung gemäß einem der Ansprüche 1 bis 3, bei der die Steuermittel, wenn die ersten Detektionsmittel mehrere Objektpositionen detektieren, die mehreren zweiten Detektionsmitteln entsprechen, die unterschiedlichen, zu steuernden Aktionen zugeordnet sind, eine Aktion nur dann steuern, wenn die zweiten Detektionsmittel eine Position eines Objekts liefern, und das nur in Abhängigkeit von der Position des Objekts, die von den zweiten Detektionsmitteln geliefert ist.

5. Vorrichtung (10) gemäß einem der Ansprüche 1 bis 4, bei der ein elektromagnetisches Feld, das von den ersten Detektionsmitteln detektiert ist, die Form einer Infrarotwelle annimmt, bei der wenigstens ein Sender (105) oder ein Empfänger (115) der ersten Detektionsmittel (105, 115 und 120) wenigstens einer Maske zugeordnet ist, deren für wenigstens eine vom Sender verwendete Wellenlänge transparenter Teil in der Richtung eines Empfängers verlängert ist, der in der Lage ist, die Welle (110, 200) in der genannten Wellenlänge zu detektieren.

6. Vorrichtung (10) gemäß einem der Ansprüche 1 bis 5, bei der ein von den ersten Detektionsmitteln detektiertes elektromagnetisches Feld die Form einer Infrarotwelle annimmt, bei der das Vorhandensein des Objekts (125, 225, 325) für eine Leistung (210) der empfangenen Welle (200) von einem Empfänger (115) der ersten Präsenz-Detektionsmittel (105, 115 und 120) detektiert ist, die niedriger ist als ein vorbestimmter Grenzwert (220).

7. Vorrichtung (10) gemäß einem der Ansprüche 1 bis 6, bei der die ersten Detektionsmittel zum Detektieren des Vorhandenseins des Objekts (125, 225, 325) für eine Interferenzintensität des Objekts auf dem elektromagnetischen Feld ausgestaltet ist, die niedriger ist als ein vorbestimmter Grenzwert (320).

8. Vorrichtung gemäß Anspruch 7, bei der der maximale vorbestimmte Grenzintensitätswert drei Viertel des Sättigungswertes der Detektionsmittel wert ist und/oder höher ist als die maximale Intensität, die während einer Lernphase mit einem Objektmuster, zum Beispiel Fingern, festgestellt ist, das die menschliche Verschiedenartigkeit von Morphologien und Hautfarben darstellt.

9. Vorrichtung gemäß einem der Ansprüche 1 bis 7, bei der der vorbestimmte Grenzgeschwindigkeitswert per Lernen durch die Vorrichtung während einer Installationsphase festgelegt ist, während der vom Nutzer verlangt wird, seinen Finger auf jedes Symbol zu richten, das eine Aktion darstellt, die geeignet ist, von der Steuervorrichtung gesteuert zu sein, wobei der minimale vorbestimmte Intensitätswert zum Beispiel zwei Mal die Intensität des gemessenen Umgebungsgeräuschs wert ist.

10. Steuerverfahren (40) einer von einem Symbol dargestellten Aktion, umfassend die folgenden Schritte:
- Detektion ohne Kontakt eines Vorhandenseins und einer Position eines Objekts, das mit einem elektromagnetischen Feld gegenüber dem Symbol interferiert,
- Bestimmung einer Verschiebungsgeschwindigkeit des Objekts in Abhängigkeit von der Position des detektierten Objekts, und
- Steuern einer Aktion, wenn die Geschwindigkeit des Objekts niedriger ist als ein vorbestimmter Grenzwert oder wenn die Geschwindigkeit des Objekts höher ist als der vorbestimmte Grenzwert und ein Aufdrücken des Nutzers auf die Vorrichtung per Kontakt detektiert wird.

11. Gerät (50), das eine von einer Aktion eines Nutzers gesteuerte Aktion realisiert, **dadurch gekennzeichnet, dass** es wenigstens eine Steuervorrichtung (10) gemäß einem der Ansprüche 1 bis 9 umfasst, die die genannte Funktion des Geräts steuert.

12. Gerät (50) gemäß Anspruch 11, das ein medizinisches Gerät bildet.

13. Gerät (50) gemäß Anspruch 11, das einen Aufzug bildet.

14. Gerät (50) gemäß Anspruch 11, das ein Haushaltsgerät bildet.

## Claims

1. Triggering device (10), comprising at least one symbol representing an action that can be triggered by the triggering device, which comprises:
- first detection means for contactless detection:
- comprising at least one emitter (105, 205, 305) of at least one wave (110, 210, 310) and at least one receiver (115, 215, 315) of the at least one wave; and
- detecting the presence and position of an object (125, 225, 325) as a function of the at least one wave received; and
- second detection means (240, 340) for detection by contact, which detect the presence and position of the object (125, 225, 325) as a function of the object pressing on the second detection means, the physical magnitude detected by the second detection means differing by at least one characteristic from the wave received by the first detection means;
- a means for determining a speed of motion of the object according to the position of the object supplied by the first detection means; and
- triggering means (100) configured to trigger an action represented by a symbol in front of the detection means if:
- the first detection means supply a position of the object, and the means for determining a speed of motion of the object determines a speed of motion of the object that is lower than a predefined speed value; or
- the first detection means supply a position of the object, and the means for determining a speed of motion of the object determines a speed of motion of the object that is greater than the predefined speed value, and the second detection means detect the user pressing on the device.

2. Device (10) according to claim 1, wherein the first detection means are configured to supply an intensity of detection of the object (125, 225, 325) according to the magnitude of the object's interference with at least one electromagnetic field,
wherein the triggering means (100) are configured to trigger an action if:
- the detection means supply a position of the object;
- the speed of the object (125, 225, 325) is lower than the predefined value; and
- the detection intensity is increasing or greater than a predefined intensity value as a function of the maximum detection intensity reached before the decrease in the detection intensity.

3. Device (10) according to one of claims 1 or 2, wherein the second detection means are only activated if the first detection means detect the presence of the object (125, 225, 325).

4. Device according to one of claims 1 to 3 wherein, if the first detection means detect several object positions corresponding to several second detection means associated with different actions to be triggered, the triggering means trigger an action only if the second detection means supply a position of an object and only as a function of the position of the object supplied by the second detection means.

5. Device (10) according to one of claims 1 to 4, wherein an electromagnetic field detected by the first detection means takes the form of an infrared wave, wherein at least one emitter (105) or receiver (115) of the first detection means (105, 115 and 120) is associated with at least one mask, whose transparent portion, for at least one wavelength used by the emitter, is elongated in the direction of a receiver able to detect the wave (110, 200) at said wavelength.

6. Device (10) according to one of claims 1 to 5, wherein an electromagnetic field detected by the first detection means takes the form of an infrared wave, wherein the presence of the object (125, 225, 325) is detected for a power (210) of the wave (200) received, by a receiver (115) of the first presence detection means (105, 115 and 120), below a predefined limit value (220).

7. Device (10) according to one of claims 1 to 6, wherein the first detection means are configured to detect the presence of the object (125, 225, 325) for an intensity of the object's interference with the electromagnetic field below a predefined limit value (320).

8. Device according to claim 7, wherein the predefined maximum intensity limit value is three-quarters of the saturation value of the detection means and/or is greater than the maximum intensity found during a learning phase with a sample of objects, e.g. fingers, representative of the human diversity of body shapes and skin colors.

9. Device according to one of claims 1 to 7, wherein the predefined speed limit value is set by the device learning during an installation phase in which the user is asked to point his finger towards each symbol representing an action that can be triggered by the triggering device, the predefined minimum intensity limit value being, for example, twice the intensity of the ambient noise measured.

10. Method (40) of triggering an action represented by a symbol, comprising the following steps:
- contactless detection of a presence and position of an object interfering with an electromagnetic field in front of the symbol;
- determination of a speed of motion of the object according to the position of the object detected; and
- triggering of an action if the speed of the object is lower than a predefined limit value, or if the speed of the object is greater than the predefined speed value and the user pressing on the device is detected by contact.

11. Appliance (50) performing a function triggered by an action by a user, **characterized in that** it comprises at least one triggering device (10) according to one of claims 1 to 9 triggering said function of the appliance.

12. Appliance (50) according to claim 11, constituting a medical appliance.

13. Appliance (50) according to claim 11, constituting an elevator.

14. Appliance (50) according to claim 11, constituting a household appliance.
